# EUROPEAN PATENT APPLICATION

(11) **EP 2 267 795 A2**
(43) Date of publication of application: **29.12.2010**
(21) Application number: 10166949.7
(22) Date of filing: 22.06.2010
(51) Int. Cl.: H01L 31/107

(54) **Avalanche photodiode**

(30) Priority: 26.06.2009 US 492903
(71) Applicant: Raytheon Company, Waltham, MA 02451-1449 (US)
(72) Inventor: Kasai, Ichiro, Solvang, CA 93463-9741 (US); Wehner, Justin G, Goleta, CA 93117 (US)
(74) Representative: Lawrence, John

(57) **Abstract**

A reverse reach-through avalanche photodiode may include a first region (202) comprising substantially intrinsic semiconductor material, the first region (202) having a first side and a second side opposite to the first side. The photodiode may also include a second region (204) comprising highly-doped p-type semiconductor material formed proximate to the first side of the first region (202). The photodiode may additionally include a third region (216) comprising highly-doped n-type semiconductor material formed proximate to the second side of the first region (202). The photodiode may further include a fourth region (214) comprising one of: (i) highly-doped p-type semiconductor formed between the first region (202) and the third region (216), or (ii) highly-doped n-type semiconductor formed between the first region (202) and the second region (204).

## Description

### TECHNICAL FIELD

This disclosure relates in general to photodetection and more particularly to a photodetection system and method utilizing one or more avalanche photodiodes.

### BACKGROUND

Photodetector circuits (e.g., focal plane arrays) are utilized in various devices to sense incident light in the visible and non-visible spectra. Photodetector circuits typically consist of an array of photodiodes that generate a charge, current, or voltage in proportion to the light intensity received at the location of each detector pixel.

Conventionally, such photodiodes include PN diodes, PiN diodes and avalanche photodiodes (APDs). APDs are photodetectors that may be regarded as photon-multipliers. By applying a reverse bias voltage to an APD (typically 10 volts or more in silicon), APDs show an internal current gain effect (a gain of approximately 10 or more) due to phenomenon known as impact ionization or the avalanche effect. Because of this large gain, APDs have found to be particularly useful in high-sensitivity photodetection. However, conventional APDs are often not suitable for "back-side" illuminated devices which may be required for certain photodetection applications, in particular large-format focal plane arrays. In addition, conventional APDs are known to multiply signal (i.e., incident light) as well as noise, which is often undesirable in high-sensitivity applications.

### SUMMARY OF THE DISCLOSURE

According to one embodiment, a photodiode may include a first region comprising substantially intrinsic semiconductor material, the region having a first side and a second side opposite to the first side. The photodiode may also include a second region comprising highly-doped p-type semiconductor material formed proximate to the first side of the first region. The photodiode may additionally include a third region comprising highly-doped n-type semiconductor material formed proximate to the second side of the first region. The photodiode may further include a fourth region comprising (i) highly-doped p-type semiconductor formed between the first region and the third region, or (ii) highly-doped n-type semiconductor formed between the first region and the second region.

Technical advantages of certain embodiments may include providing a photodiode with higher signal-to-noise ratio as compared with conventional photodiodes.

Other technical advantages will be readily apparent to one skilled in the art from the following figures, descriptions, and claims. Moreover, while specific advantages have been enumerated above, various embodiments may include all, some, or none of the enumerated advantages.

### BRIEF DESCRIPTION OF THE DRAWINGS

For a more complete understanding of the present disclosure and its advantages, reference is now made to the following description, taken in conjunction with the accompanying drawings, in which:
FIGURE 1 is a simplified schematic diagram illustrating a photodetection system, in accordance with embodiments of the present disclosure;
FIGURE 2 depicts a reverse reach-through APD that may be an integral part of a photodetector depicted in FIGURE 1, in accordance with certain embodiments of the present disclosure;
FIGURE 3 depicts an electric field strength profile of the APD depicted in FIGURE 2 in a reverse-biased configuration, in accordance with certain embodiments of the present disclosure; and
FIGURE 4 depicts another reverse reach-through APD that may be an integral part of a photodetector depicted in FIGURE 1, in accordance with certain embodiments of the present disclosure.

### DETAILED DESCRIPTION OF THE DISCLOSURE

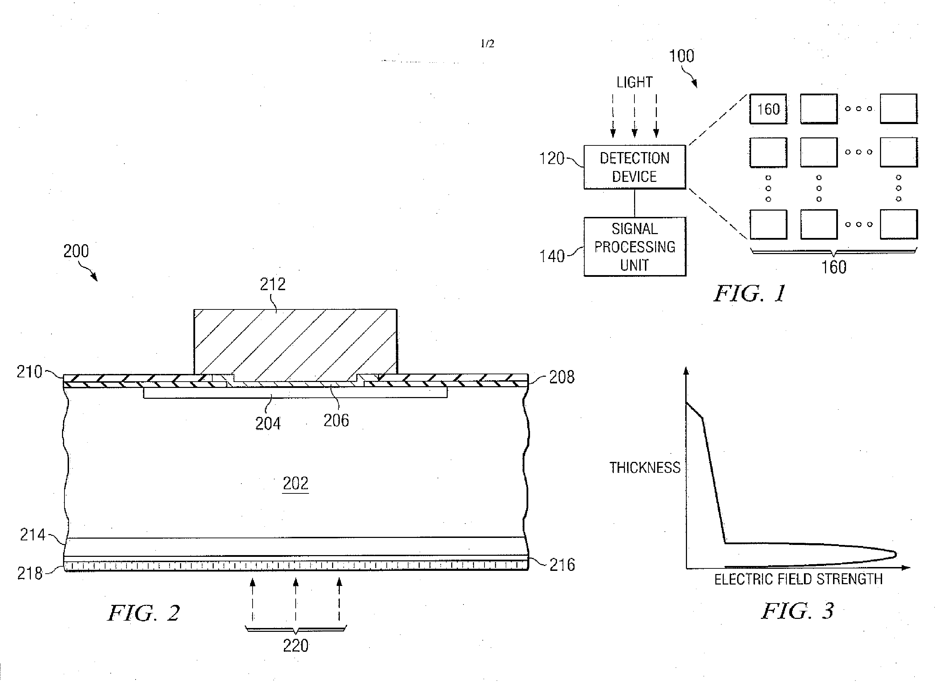

Embodiments of the present disclosure and its advantages are best understood by referring to FIGURES 1 through 4 of the drawings, like numerals being used for like and corresponding parts of the various drawings.

FIGURE 1 is a block diagram illustrating photodetection system 100, in accordance with embodiments of the present disclosure. For example, photodetection system 100 may be a digital camera, video camera, or any other photographic device, image capturing device, and/or high-speed photon counting device. Photodetection system 100 may include detection device 120 and signal processing unit 140. Detection device 120 may be a focal plane array (FPA), active pixel sensor (APS) or any other suitable light sensing device that can capture photons. Detection device 120 may include, for example, one or more diodes, complimentary metal-oxide semiconductors (CMOSs), charge-coupled devices (CCDs), or any other suitable photovoltaic detectors or transducers. Signal processing unit 140 may be a combination of hardware, software, or firmware that is operable to receive signal information from detection device 120 and convert the signal information into electronic data.

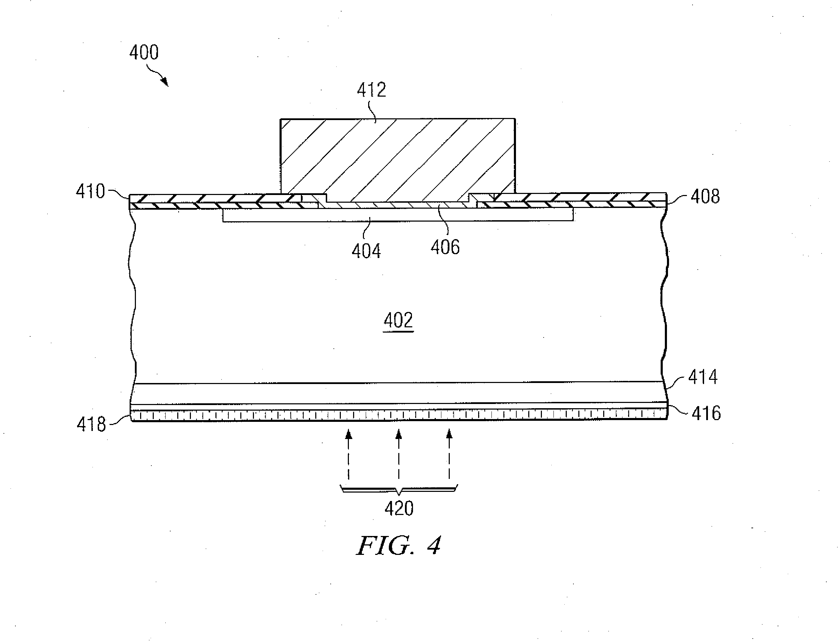

Detection device 120 may include an array of unit cells 160. Unit cells 160 may accumulate charge or produce a current and/or voltage proportional to the light intensity of light incident upon the unit cell and may correspond to a pixel in a captured electronic signal. The accumulated charge or the produced current and/or voltage may be used by processing unit 140 for processing of the incident light (e.g., to create a signal representative of the incident light). In certain embodiments, one or more of unit cells 160 may include a reverse reach-through APD, such as the reverse reach-through APDs depicted in FIGURES 2 and 4.

FIGURE 2 depicts a reverse reach-through APD 200 that may be an integral part of a unit cell 160 depicted in FIGURE 1, in accordance with certain embodiments of the present disclosure. As shown in FIGURE 2, APD 200 may include substrate 202, a highly-doped front-side p-type region 204, a contact 206, field oxides 208, overglass 210, bump 212, highly-doped back-side p-type region 214, highly-doped back-side n-type region 216, and antireflective coating 218.

Substrate 202 may comprise any substantially intrinsic semiconductor substrate (e.g., undoped or lightly-doped intrinsic semiconductor), including without limitation silicon, germanium, silicon carbide, gallium antimonide, gallium arsenide, gallium nitride, gallium phosphide, indium antimonide, indium arsenide, indium nitride, indium phosphide, or other suitable semiconductor material. In some embodiments, substrate 202 may be a lightly p-type doped (π) semiconductor (e.g., silicon doped with boron or other acceptor atom). In embodiments in which substrate 202 comprises silicon, it may have a thickness of between approximately 10 µm and approximately 40 µm. In embodiments in which substrate 202 comprises silicon, substrate 202 may have a resitivity of approximately 10 kΩ-cm or greater.

Highly-doped front-side p-type region 204 may be formed in or on substrate 202 via implantation, deposition, epitaxy, or any other suitable fabrication technique. For example, highly-doped front-side p-type region 204 may be formed by implanting acceptor atoms (e.g., implanting boron atoms into a silicon substrate) on the front-side surface of substrate 202. In other embodiments, highly-doped front-side p-type region 204 may be formed by epitaxy. In embodiments in which substrate 202 comprises silicon, highly-doped front-side p-type region 204 may be implanted to a depth of approximately 0.5 µm. In embodiments in which substrate 202 comprises silicon, highly-doped front-side p-type region 204 may have a p-type dopant concentration between approximately 5x10¹⁸ cm⁻³ and approximately 1x10¹⁹ cm⁻³. In some embodiments, highly-doped front-side p-type region 204 may define a pixel area of a detection device (e.g., detection device 120).

Contact 206 may be coupled to highly-doped front-side p-type region 204 and may include a generally conductive material (e.g., aluminum, silver, copper, gold, or other suitable metal) to electrically couple highly-doped front-side p-type region 204 to bump 212 and/or other electrical and/or electronic circuitry external to APD 200. Contact 206 may be formed on substrate 202 via deposition or any other suitable fabrication technique. For example, contact 206 may be formed by depositing aluminum upon highly-doped front-side p-type region 204.

Field oxides 208 may be formed on the front-side surface of substrate 202 in order to provide surface passivation of substrate 202. Field oxides 208 may be formed in any suitable manner. For example, in embodiments in which substrate 202 comprises silicon, field oxides 208 may be formed by growing silicon dioxide on the substrate.

Overglass 210 may be formed over field oxides 208 in order to environmentally protect the surface of substrate 202. Overglass 210 may be formed in any suitable manner. For example, in embodiments in which substrate 202 comprises silicon, silicon dioxide overglass may be formed by plasma oxidation or silicon nitride (Si₂N₃) overglass may be formed by plasma enhanced chemical vapor deposition.

Bump 212 may be coupled to contact 206 and may include a generally conductive material (e.g., indium or other suitable metal) to electrically couple contact 206 to other electrical and/or electronic circuitry external to APD 200. Bump 212 may be formed on substrate 202 via any suitable fabrication technique. For example, bump 212 may be formed by electrochemical plating, vacuum deposition of indium, Direct Bond Interconnect, or other suitable fabrication technique.

Highly-doped back-side p-type region 214 may be formed in or on substrate 202 via implantation, deposition, epitaxy, or any other suitable fabrication technique. For example, highly-doped back-side p-type region 214 may be formed by implanting acceptor atoms (e.g., implanting boron into a silicon substrate) on the back-side surface of substrate 202 to create a highly-doped p-type layer. In other embodiments, highly-doped back-side p-type region 214 may be formed by epitaxy. In embodiments in which substrate 202 comprises silicon, highly-doped back-side p-type region 214 may have a thickness of approximately 0.5 µm to approximately 3.0 µm at a peak implant depth of between approximately 1.0 µm and approximately 2.0 µm. In embodiments in which substrate 202 comprises silicon, highly-doped back-side p-type region 214 may have a p-type dopant concentration between approximately 8x10¹⁶ cm⁻³ and approximately 2x10¹⁷ cm⁻³.

Highly-doped back-side n-type region 216 may be formed in or on substrate 202 via implantation, deposition, epitaxy, or any other suitable fabrication technique. For example, highly-doped back-side n-type region 216 may be formed by implanting donor atoms (e.g., implanting arsenic or phosphorous into a silicon substrate) on the back-side surface of substrate 202 to create a highly-doped n-type layer. In embodiments in which substrate 202 comprises silicon, highly-doped back-side n-type region 216 may have a thickness of approximately 0.1 µm at an implant depth of approximately 0.1 µm. After implantation, substrate 202 may be annealed (e.g., via laser or thermal annealing) to activate the implanted dopants (e.g., dopants implanted to create highly-doped back-side p-type region 214 and highly-doped back-side n-type region 216). In some embodiments, highly-doped back-side n-type region 216 may have a n-type dopant concentration between approximately 5x10¹⁹ cm⁻³ and approximately 1x10²⁰ cm⁻³. Highly-doped back-side n-type region 216 may be electrically coupled to a contact, and such contact may further be coupled to electric and/or electronic circuitry external to APD 200.

Antireflective coating 218 may be formed on the back-side of substrate 202 and to reduce the reflection of light incident upon APD 200, thus improving the efficiency of the APD 200 as less light is lost via reflection. In embodiments in which substrate 202 comprises silicon, antireflective coating 218 may comprise magnesium fluoride or any other suitable material (e.g., multi-layer materials). Antireflective coating 218 may be formed on substrate 202 using physical vapor deposition or any other suitable fabrication technique. In embodiments in which substrate 202 comprises silicon, antireflective coating 218 may have a thickness of approximately 0.16 µm.

In applications in which numerous APDs 200 are used in an array of unit cells (e.g., detection device 120), certain portions of one or more APDs 200 may be common to each other. For example, each APD 200 in an array may have a common substrate 202, a common highly-doped back-side p-type region 214, a common highly-doped back-side n-type region 216, and a common antireflective coating 218. In such an array, each individual APD 200 may have its own highly-doped front-side p-type region 204, contact 206, and bump 212 defining a pixel in the array.

In the configuration shown in FIGURE 2, APD 200 includes a p-n junction formed by highly-doped back-side p-type region 214 and highly-doped back-side n-type region 216. In operation, a reverse bias may be applied to the p-n junction (e.g., a negative electric potential applied to highly-doped back-side n-type region 216 referenced to contact 206 and/or bump 212). Such reverse bias may create an electric field strength profile within APD 200 similar to that depicted in FIGURE 3. If the applied reverse bias voltage is large enough (e.g., approximately 30 volts or greater in embodiments in which substrate 202 comprises silicon) an avalanche region of a relatively high field strength may be formed proximate to the p-n junction, such that free electrons present in the avalanche region may be accelerated by the electric field present in the avalanche region such that the free electrons may strike other atoms in the avalanche region, in turn creating more free electrons through impact ionization. The reverse bias may also create a depletion region across the undoped or lightly doped portion of substrate 202 in which free carriers (e.g., electrons and holes) may be accelerated to produce an electrical current.

Accordingly, a photon of light 220 impinging on the back-side of APD 200 may excite an electron, thereby creating a mobile electron and a positively charged electron hole in the avalanche region, which may in turn create more mobile electrons and holes through impact ionization. Such electrons and holes may be swept by the built-in field of the depletion and avalanche regions (e.g., electrons toward highly-doped back-side n-type region 216 and holes toward the contact 206) producing a photocurrent proportional to the intensity of impinging light 220.

FIGURE 4 depicts another reverse reach-through APD 400 that may be an integral part of a unit cell 160 depicted in FIGURE 1, in accordance with certain embodiments of the present disclosure. As shown in FIGURE 4, APD 400 may include substrate 402, a highly-doped front-side n-type region 404, a contact 406, field oxides 408, overglass 410, bump 412, highly-doped back-side n-type region 414, highly-doped back-side p-type region 416, and antireflective coating 418. APD 400 may be similar to APD 200 except that highly-doped front-side p-type region 204 is replaced by highly-doped front-side n-type region 404, highly-doped back-side p-type region 214 is replaced by highly-doped back-side n-type region 414, highly-doped back-side n-type region 216 is replaced by highly-doped back-side p-type region 416, and substrate 202 is replaced with substrate 402.

Substrate 402 may comprise any substantially intrinsic semiconductor substrate (e.g. undoped or lightly-doped semiconductor), including without limitation silicon, germanium, silicon carbide, gallium antimonide, gallium arsenide, gallium nitride, gallium phosphide, indium antimonide, indium arsenide, indium nitride, indium phosphide, or other suitable semiconductor material. In some embodiments, substrate 202 may be a lightly n-type doped (v) semiconductor (e.g., silicon doped with arsenic, phosphorous, or other acceptor atom). In the same or alternative embodiments, substrate 402 may have a thickness of between approximately 10 µm and approximately 40 µm. In embodiments in which substrate 402 comprises silicon, substrate 402 may have a resitivity of approximately 10 kΩ-cm or greater.

Highly-doped front-side n-type region 404 may be formed in or on substrate 402 via implantation, deposition, epitaxy, or any other suitable fabrication technique. For example, highly-doped front-side n-type region 404 may be formed by implanting donor atoms (e.g., implanting arsenic and/or phosphorous into a silicon substrate) on the front-side surface of substrate 402. In other embodiments, highly-doped front-side n-type region 404 may be formed by epitaxy. In embodiments in which substrate 402 comprises silicon, highly-doped front-side n-type region 404 may be implanted to a depth of approximately 0.5 µm. In embodiments in which substrate 402 comprises silicon, highly-doped front-side n-type region 404 may have a n-type dopant concentration between approximately 5x10¹⁸ cm⁻³ and approximately 1x10¹⁹ cm⁻³. In some embodiments, highly-doped front-side n-type region 404 may define a pixel area of a detection device (e.g., detection device 120).

Contact 406 may be coupled to highly-doped front-side n-type region 404 and may include a generally conductive material (e.g., aluminum, silver, copper, gold, or other suitable metal) to electrically couple highly-doped front-side n-type region 404 to bump 412 and/or other electrical and/or electronic circuitry external to APD 400. Contact 406 may be formed on substrate 402 via deposition or any other suitable fabrication technique. For example, contact 406 may be formed by depositing aluminum upon substrate 402.

Field oxides 408 may be formed on the front-side surface of substrate 402 in order to provide surface passivation of substrate 402. Field oxides 408 may be formed in any suitable manner. For example, in embodiments in which substrate 402 comprises silicon, field oxides 408 may be formed by growing silicon dioxide on the substrate.

Overglass 410 may be formed over field oxides 408 in order to environmentally protect the surface of substrate 402. Overglass 410 may be formed in any suitable manner. For example, in embodiments in which substrate 402 comprises silicon, silicon dioxide overglass may be formed by plasma oxidation or silicon nitride (Si₂N₃) overglass may be formed by plasma enhanced chemical vapor deposition.

Bump 412 may be coupled to contact 406 and may include a generally conductive material (e.g., indium or other suitable metal) to electrically couple contact 406 to other electrical and/or electronic circuitry external to APD 400. Bump 412 may be formed on substrate 402 via any suitable fabrication technique. For example, bump 412 may be formed by electrochemical plating, vacuum deposition of indium, Direct Bond Interconnect, or any other suitable fabrication technique.

Highly-doped back-side n-type region 414 may be formed in or on substrate 402 via implantation, deposition, epitaxy, or any other suitable fabrication technique. For example, highly-doped back-side n-type region 414 may be formed by implanting donor atoms (e.g., implanting arsenic or phosphorous into a silicon substrate) on the back-side surface of substrate 402 to create a highly-doped n-type layer. In other embodiments, highly-doped back-side n-type region 414 may be formed by epitaxy. In embodiments in which substrate 402 comprises silicon, highly-doped back-side n-type region 414 may have a thickness of approximately 1.0 µm at a peak implant depth of between approximately 1.0 µm and approximately 2.0 µm. In embodiments in which substrate 402 comprises silicon, highly-doped back-side n-type region 414 may have a n-type dopant concentration between approximately 8x10¹⁶ cm⁻³ and approximately 2x10¹⁷ cm⁻³.

Highly-doped back-side p-type region 416 may be formed in or on substrate 402 via implantation, deposition, epitaxy, or any other suitable fabrication technique. For example, highly-doped back-side p-type region 416 may be formed by implanting acceptor atoms (e.g., implanting boron into a silicon substrate) on the back-side surface of substrate 402 to create a highly-doped p-type layer. In embodiments in which substrate 402 comprises silicon, highly-doped back-side p-type region 416 may have a thickness of approximately 0.1 µm at an implant depth of approximately 0.1 µm. After implantation, substrate 402 may be annealed (e.g., via laser or thermal annealing) to activate the implanted dopants (e.g., dopants implanted to create highly-doped back-side n-type region 414 and highly-doped back-side p-type region 416). In embodiments in which substrate 402 comprises silicon, highly-doped back-side p-type region 416 may have a p-type dopant concentration between approximately 5x10¹⁹ cm⁻³ and approximately 1x10²⁰ cm⁻³. Highly-doped back-side p-type region 416 may be electrically coupled to a contact and such contact may further be coupled to electric and/or electronic circuitry external to APD 400.

Antireflective coating 418 may be formed on the back-side of substrate 402 and to reduce the reflection of light incident upon APD 400, thus improving the efficiency of the APD 400 as less light is lost via reflection. Antireflective coating 418 may comprise magnesium fluoride or any other suitable material (e..g, multi-layer materials). Antireflective coating 418 may be formed on substrate 402 using physical vapor deposition or any other suitable fabrication technique. In embodiments in which substrate 402 comprises silicon, antireflective coating 418 may have a thickness of approximately 0.16 µm.

In applications in which numerous APDs 400 are used in an array of unit cells (e.g., detection device 120), certain portions of one or more APDs 400 may be common to each other. For example, each APD 400 in an array may have a common substrate 402, a common highly-doped back-side n-type region 414, a common highly-doped back-side p-type region 416, and a common antireflective coating 418. In such an array, each individual APD 400 may have its own highly-doped front-side n-type region 404, contact 406, and bump 412 defining a pixel in the array.

In the configuration shown in FIGURE 4, APD 400 includes a p-n junction formed by highly-doped back-side n-type region 414 and highly-doped back-side p-type region 416. In operation, a reverse bias may be applied to the p-n junction (e.g., a positive electric potential applied to contact 206 and/or bump 212 referenced to highly-doped back-side p-type region 416). Such reverse bias may create an electric field strength profile within APD 400 similar to that depicted in FIGURE 3. If the applied reverse bias voltage is large enough (e.g., approximately 40 volts or greater in embodiments in which substrate 402 comprises silicon) an avalanche region of a relatively high field strength may be formed proximate to the p-n junction, such that free electrons present in the avalanche region may be accelerated by the electric field present in the avalanche region such that the free electrons may strike other atoms in the avalanche region, in turn creating more free electrons through impact ionization. The reverse bias may also create a depletion region across the undoped or lightly doped portion of substrate 402 in which free carriers (e.g., electrons and holes) may be accelerated to produce an electrical current.

Accordingly, a photon of light 420 impinging on the back-side of APD 400 may excite an electron, thereby creating a mobile electron and a positively charged electron hole in the avalanche region, which may in turn create more mobile electrons and holes through impact ionization. Such electrons and holes may be swept by the built-in field of the depletion and avalanche regions (e.g., holes toward highly-doped back-side p-type region 216 and electrons toward the contact 206) producing a photocurrent proportional to the intensity of impinging light 220.

An advantage of APDs such as APD 200 and APD 400 is that such APDs may have a higher signal-to-noise ratio (SNR) as compared with conventional APDs. In traditional reach-through APDs, noise generated in a depletion region is often multiplied through impact ionization in the avalanche region. However, in a reverse reach-through APD such as the APDs depicted in FIGURES 2 and 4, optically-generated free electrons may be multiplied whereas noise multiplication may be reduced as compared to traditional approaches. In addition, the buried p-n junctions may render the APD less sensitive to surface conditions, resulting in lower surface dark current compared and stronger radiation hardening characteristics as compared with traditional approaches.

In addition, reverse reach-through APDs such as the APDs depicted in FIGURES 2 and 4 may be relatively simple to fabricate, as the structure of the APDs depicted in FIGURES 2 and 4 are similar to those of a traditional PiN diode with either an additional highly-doped p-type region (e.g., highly-doped back-side p-type region 214 in FIGURE 2) or an additional highly-doped n-type region (highly-doped back-side n-type region 414 in FIGURE 4).

Although the embodiments in the disclosure have been described in detail, numerous changes, substitutions, variations, alterations, and modifications may be ascertained by those skilled in the art. Additionally or alternatively, while the disclosure may be described predominantly in reference to visible detectors, the embodiments disclosed herein may be utilized with many types of detectors including, but not limited to, visible, infrared, ultraviolet, x-ray, or other radiation detectors. It is intended that the present disclosure encompass all such changes, substitutions, variations, alterations and modifications as falling within the spirit and scope of the appended claims.

It will be appreciated that optional features of embodiments of the invention can be used together in any number and in any combination. This includes, but is not limited to, using the features of dependent claims in any number, and in any combination.

## Claims

1. A photodiode (200) comprising:
a first region (202) comprising substantially intrinsic semiconductor material, the first region (202) having a first side and a second side opposite to the first side;
a second region (204) comprising highly-doped p-type semiconductor material formed proximate to the first side of the first region (202);
a third region (216) comprising highly-doped n-type semiconductor material formed proximate to the second side of the first region (202); and
a fourth region (214) comprising one of: (i) highly-doped p-type semiconductor formed between the first region (202) and the third region (216), or (ii) highly-doped n-type semiconductor formed between the first region (202) and the second region (204).

2. The photodiode (200) of Claim 1, wherein the first region (202), the second region (204), the third region (216), and the fourth region (214) are formed on the same semiconductor substrate.

3. The photodiode (200) of Claim 1, wherein at least one of the second region (204) and the fourth region (214) is formed by one of: (i) implantation of acceptor atoms into the semiconductor substrate and (ii) acceptor-doped epitaxial growth.

4. The photodiode (200) of Claim 1, wherein at least one of the third region (216) and the fourth region (214) is formed by one of: (i) implantation of donor atoms into the semiconductor substrate and (ii) donor-doped epitaxial growth.

5. The photodiode (200) of Claim 1, wherein:
the fourth region (214) comprises highly-doped p-type semiconductor formed between the first region (202) and the third region (216); and
the first region (202) comprises lightly-doped p-type semiconductor material.

6. The photodiode (200) of Claim 1, wherein:
the fourth region (214) comprises highly-doped n-type semiconductor formed between the first region (202) and the second region (204); and
the first region (202) comprises lightly-doped n-type semiconductor material.

7. The photodiode (200) of Claim 1, wherein one of the second region (204) and the third region (216) defines a pixel area of the photodiode (200).

8. A system (100) for photodetection comprising:
at least one photodiode (200) according to any of Claims 1-7 and operable to generate an electric signal in proportion to an intensity of light incident on the at least one photodiode (200); and
a processing unit (140) communicatively coupled to the at least one photodiode (200).

9. The system (100) of Claim 8, wherein the electric signal is one of a voltage, a current and an electric charge.

10. The system (100) of Claim 8, comprising a focal plane array including the at least one photodiode (200).

11. A method for photodetection comprising:
forming a first region (202) comprising substantially intrinsic semiconductor material, the first region (202) having a first side and a second side opposite to the first side;
forming a second region (204) comprising highly-doped p-type semiconductor material formed proximate to the first side of the first region (202);
forming a third region (216) comprising highly-doped n-type semiconductor material formed proximate to the second side of the first region (202); and
forming a fourth region (214) comprising one of: (i) highly-doped p-type semiconductor formed between the first region (202) and the third region (216), or (ii) highly-doped n-type semiconductor formed between the first region (202) and the second region (204).

12. The method of Claim 11, wherein the first region (202), the second region (204), the third region (216), and the fourth region (214) are formed on the same semiconductor substrate.

13. The method of Claim 11, wherein at least one of the second region (204) and the fourth region (214) is formed by one of: (i) implantation of acceptor atoms into the semiconductor substrate and (ii) acceptor-doped epitaxial growth.

14. The method of Claim 11, wherein at least one of the third region (216) and the fourth region (214) is formed by one of: (i) implantation of donor atoms into the semiconductor substrate and (ii) donor-doped epitaxial growth.

15. The method of Claim 11, wherein:
the fourth region (214) comprises highly-doped p-type semiconductor formed between the first region (202) and the third region (216); and
the first region (202) comprises lightly-doped p-type semiconductor material.

16. The method of Claim 11, wherein:
the fourth region (214) comprises highly-doped n-type semiconductor formed between the first region (202) and the second region (204); and
the first region (202) comprises lightly-doped n-type semiconductor material.
